# Europäisches Patentamt

# European Patent Office

# Office européen des brevets

(11) Veröffentlichungsnummer: **0 173 057**

**B1**

(12) **EUROPÄISCHE PATENTSCHRIFT**

(45) Veröffentlichungstag der Patentschrift:
15.02.89

(51) Int. Cl.⁴: **G 03 C 1/68**

(21) Anmeldenummer: 85108927.6

(22) Anmeldetag: 17.07.85

(54) Durch Strahlung polymerisierbares Gemisch.

(30) Priorität: 26.07.84 DE 3427519

(43) Veröffentlichungstag der Anmeldung:
05.03.86 Patentblatt 86/10

(45) Bekanntmachung des Hinweises auf die Patenterteilung:
15.02.89 Patentblatt 89/7

(84) Benannte Vertragsstaaten:
AT BE CH DE FR GB IT LI NL SE

(56) Entgegenhaltungen:
DE-A-2 363 806
DE-A-2 509 473
DE-A-3 028 136
US-A-3 554 913

Die Akte enthält technische Angaben, die nach dem Eingang der Anmeldung eingereicht wurden und die nicht in dieser Patentschrift enthalten sind.

(73) Patentinhaber: HOECHST AKTIENGESELLSCHAFT, Postfach 80 03 20, D-6230 Frankfurt am Main 80 (DE)
Patentinhaber: Röhm GmbH, Kirschenallee Postfach 4242, D-6100 Darmstadt 1 (DE)

(72) Erfinder: Geissler, Ulrich, Dr. Dipl.- Ing., Altenauer Strasse 34, D-6203 Hochheim/Main (DE)
Erfinder: Albrecht, Klaus, Dr. Dipl.- Ing., Vogelsbergstrasse 20, D-6500 Mainz 42 (DE)

(74) Vertreter: Euler, Kurt Emil, Dr., KALLE Niederlassung der Hoechst AG Rheingaustrasse 190 Postfach 3540, D-6200 Wiesbaden 1 (DE)

**Beschreibung**

Die Erfindung betrifft ein Gemisch, das als wesentliche Bestandteile

a) eine radikalisch polymerisierbare Verbindung mit mindestens zwei endständigen ethylenisch ungesättigten Gruppen und mit einem Siedepunkt oberhalb 100°C bei Normaldruck,

b) eine Verbindung, die unter Einwirkung von aktinischer Strahlung die Polymerisation der Verbindung a) zu initiieren vermag, und

c) ein wasserunlösliches, in wäßrig-alkalischen Lösungen lösliches Mischpolymerisat enthält.

Polymerisierbare Gemische der genannten Gattung sind bekannt und werden u.a. zur Herstellung von photopolymerisierbaren Druckplatten und Photoresistmaterialien verwendet. Ein bevorzugtes Anwendungsgebiet für derartige Gemische ist die Herstellung von Trockenphotoresistmaterialien.

In der DE-A-2 064 080 sind derartige Gemische beschrieben, die als Bindemittel Mischpolymerisate von Methacrylsäure und Alkylmethacrylaten mit mindestens 4 Kohlenstoffatomen in der Alkylgruppe, bevorzugt Terpolymerisate von Methacrylsäure, Methyl- oder Ethylmethacrylat und einem Alkylmethacrylat mit 4 bis 15 Kohlenstoffatomen in der Alkylgruppe enthalten. Diese Gemische bilden gut haftende, flexible Schichten, die aber in höheren Dicken, etwa oberhalb 20 µm, zu kaltem Fluß neigen und deshalb bei längerer Lagerung in Form von beschichteten, aufgewickelten Trockenresistfolien am Rand austreten und verkleben.

In der DE-A-2 363 806 sind ähnliche Gemische beschrieben, die Terpolymerisate aus Methacrylsäure, einem Alkylmethacrylat mit mindestens 4 Kohlenstoffatomen in der Alkylgruppe und einem weiteren Monomeren enthalten, dessen zugehöriges Homopolymerisat eine Glastemperatur von mindestens 80°C aufweist. Als solche Monomere werden insbesondere Styrol, substituierte Styrole und Acrylnitril genannt. Diese Gemische haben einen erheblich reduzierten kalten Fluß, sie sind jedoch für bestimmte Anwendungen, wie das Überspannen von Löchern im Basismaterial, die sogenannte Tenting-Technik, nur beschränkt oder gar nicht geeignet. Die Tenting-Technik wird in zunehmendem Maße zur Herstellung von Leiterplatten eingesetzt. Bei der Verarbeitung nach dem Subtraktiv-Verfahren werden die gebohrten und gebürsteten Platten in den Bohrungen chemisch metallisiert und dann im galvanischen Kupferbad über die gesamte Oberfläche auf die geforderte Endschichtdicke verstärkt. Danach wird mit Photoresist laminiert und anschließend belichtet. Dabei wird die Resistschicht in den Bereichen der Leiterzüge und Lötaugen gehärtet. Die Bohrungen werden beidseitig durch gehärtete Resistbereiche überdeckt, die beim Entwickeln der Schicht zurückbleiben. Die freigelegten Bereiche der Kupferschicht werden weggeätzt.

Die Tenting-Technik ist außerdem beim Abdecken von sogenannten Greif- bzw. Positionslöchern von Wichtigkeit. Dies sind Löcher mit einem Durchmesser bis zu 6 mm und darüber, die in den Platten für die Handhabung bei verschiedenen Behandlungsschritten vorgesehen sind. Bei dem semiadditiven Verfahren wird an den nicht von der Resistschablone abgedeckten Bereichen galvanisch Metall abgeschieden. Hierbei müssen auch die Positionslöcher abgedeckt sein, da sie sonst durch Metallabscheidung verengt und damit für weitere Schritte unbrauchbar gemacht würden. Danach wird die Resistschablone entfernt und das darunterliegende Leitkupfer mit einem Ätzmittel fortgeätzt, wobei auch das in den Greif- bzw. Positionslöchern vorhandene Kupfer entfernt wird.

Die Tenting-Technik stellt somit hohe Anforderungen an den Photoresist. Er muß im belichteten Zustand flexibel sowie ätz- und galvanoresistent sein und Bohrungen von 6 mm und mehr freitragend überdecken.

In der DE-B-2 517 656 werden weitere ähnliche Gemische beschrieben, die als Bindemittel eine Kombination von zwei sauren Polymeren enthalten, von denen unter bestimmten Bedingungen das eine in verdünnter wäßriger Natronlauge löslich, das andere unlöslich ist. Die dort beschriebenen Methacrylsäure-Mischpolymerisate sind in der wäßrigen Natronlauge unlöslich.

Aufgabe der Erfindung war es, ein durch Strahlung polymerisierbares Gemisch vorzuschlagen, das zur Herstellung von Trockenphotoresistmaterialien geeignet ist, das sich leicht und vollständig mit wäßrig-alkalischen Lösungen entwickeln läßt, Schichten mit hoher Flexibilität und geringem kalten Fluß bildet und das ferner geeignet ist, beim Laminieren auf gebohrte kupferbeschichtete Isolierstoffplatten Bohrlöcher von mehr als 1 mm Durchmesser zu überspannen und in Form des so entstandenen selbsttragenden Films nach dem Belichten weitere Behandlungsschritte, wie die Sprühentwicklung, das Ätzen und Galvanisieren, ohne Beschädigung zu überstehen.

Gegenstand der Erfindung ist ein durch Strahlung polymerisierbares Gemisch, das als wesentliche Bestandteile

a) eine radikalisch polymerisierbare Verbindung mit mindestens zwei endständigen ethylenisch ungesättigten Gruppen und mit einem Siedepunkt oberhalb 100°C bei Normaldruck,

b) eine Verbindung, die unter Einwirkung von aktinischer Strahlung die Polymerisation der Verbindung a) zu initiieren vermag, und

c) ein wasserunlösliches, in wäßrig-alkalischen Lösungen lösliches Mischpolymerisat aus

c1) einer α, β-ungesättigten aliphatischen Carbonsäure,

c2) einem Alkylmethacrylat mit mindestens 4 Kohlenstoffatomen in der Alkylgruppe und gegebenenfalls

c3) einer mit c1) und c2) mischpolymerisierbaren monomeren ethylenisch ungesättigten Verbindung enthält, deren zugehöriges Homopolymerisat eine Glastemperatur von mindestens 80°C hat.

Das erfindungsgemäße Gemisch ist dadurch gekennzeichnet, daß das Mischpolymerisat ein mittleres Molekulargewicht im Bereich von etwa 50.000 bis 200.000 hat und durch Polymerisation in der Masse hergestellt worden ist.

Schichten mit guter Flexibilität und Zähigkeit bei gleichzeitig ausreichender Entwickelbarkeit in wäßrig-alkalischen Lösungen werden mit solchen Gemischen erhalten, in denen das Mischpolymerisat ein Molekulargewicht von 65.000 bis 150.000 hat.

Das Mischpolymerisat enthält als ungesättigte aliphatische Carbonsäure c1 bevorzugt Acrylsäure, Methacrylsäure, Crotonsäure, Sorbinsäure, Maleinsäure, Itaconsäure oder Halbester der genannten Dicarbonsäuren. Als ganz besonders vorteilhaft hat sich die Methacrylsäure erwiesen.

Das Alkylmethacrylat c2 hat vorzugsweise 4 bis 20, insbesondere 6 bis 12, Kohlenstoffatome in der Alkylgruppe. Sein zugehöriges Homopolymerisat soll bevorzugt eine Glastemperatur von höchstens 20°C aufweisen.

Mischpolymerisate, die allein aus den Komponenten c1 und c2 bestehen, sind als Bindemittel geeignet, wenn die ungesättigte Carbonsäure c1 ein Homopolymerisat mit einem Tg-Wert oberhalb 80° bevorzugt von mindestens 100°C, bildet. Mit dem Säuregehalt steigt die Glastemperatur dieser Mischpolymerisate auch ohne Zusatz einer Komponente c3. Mischpolymerisate mit höherer Glastemperatur ermöglichen wiederum eine Erhöhung des Monomeranteils in der Schicht, ohne daß es zu kaltem Fluß kommt. In der Regel werden für viele Anwendungen diese Mischpolymerisate aus zwei Komponenten bevorzugt, da sie sich einfach herstellen und in ihrer Zusammensetzung leichter reproduzieren lassen als Mischpolymerisate aus drei oder mehr Komponenten.

In vielen Fällen, in denen es erwünscht ist, die Glastemperatur des Mischpolymerisats unabhängig von dessen Säurezahl zu variieren oder in denen andere Eigenschaften gezielt beeinflußt werden sollen, ist es aber vorteilhaft, ein weiteres Monomeres c3 einzusetzen, das Homopolymerisate mit Tg-Werten von mindestens 80°C, bevorzugt mindestens 100°C, bildet. Als solche Monomere sind z. B. geeignet:

Styrol oder substituierte Styrole, wie Vinyltoluol, 4-Chlorstyrol, Propen-2-yl-benzol, Vinyl-ethyl-benzol, 2-Methoxy-styrol; Vinylnaphthalin oder substituierte Vinylnaphthaline; Vinylheterocyclen wie N-Vinylcarbazol, Vinylpyridin, Vinyloxazol; Vinylcycloalkane wie Vinylcyclohexan und 3,5-Dimethylvinylcyclohexan; Acrylamid, Methacrylamid, N-substituierte Acrylamide bzw. Methacrylamide, Acrylnitril, Methacrylnitril und Arylmethacrylate.

Bevorzugt werden Styrol oder substituierte Styrole, Acrylamid, Methacrylamid, Acrylnitril und Methacrylnitril, insbesondere Styrol.

Selbstverständlich können von den Komponenten c1, c2 und c3 auch jeweils mehrere Vertreter enthalten sein.

Der Mengenanteil der Komponente c1 beträgt im allgemeinen 20 bis 60, bevorzugt 30 bis 55 mol-%; der Mengenanteil an Komponente c2 je nach Kettenlänge 25 bis 80, vorzugsweise 35 bis 65 und der Mengenanteil an Komponente c3 0 bis 30, bevorzugt 3 bis 20 mol-%. Die Gesamtmenge an Monomeren mit zugehörigen Tg-Werten von mindestens 80°C, also von c1 und c3, beträgt bevorzugt mindestens 35 mol-%. Die Säurezahl des Mischpolymerisats liegt vorzugsweise im Bereich von 170 - 250.

Damit die Mischpolymerisate den Anforderungen an die Verarbeitung im Trockenresistverfahren genügen, ist es erforderlich, daß ihre Glastemperatur Tg innerhalb eines bestimmten Bereichs liegt. Die Tg-Werte von Mischpolymerisaten lassen sich näherungsweise aus den Tg-Werten der Homopolymerisate der einzelnen Komponenten nach der folgenden Formel berechnen:

$$\frac{100}{Tg_{MP}} = \frac{m_A}{Tg_A} + \frac{m_B}{Tg_B} + \frac{m_C}{Tg_C} + \ldots$$

Dabei bedeuten

| | |
|---|---|
| $Tg_{MP}$ | Glastemperatur des Mischpolymerisats (in Kelvin) |
| $Tg_A$ (B, C ..) | Glastemperatur des Homopolymerisats von A (B, C usw.) (in Kelvin) |
| $m_A$ (B, C..) | Mengenanteil an A (B, C usw.) im Mischpolymerisat in Gew.-%. |

Die Tg-Werte des Mischpolymerisats in dem erfindungsgemäßen Gemisch sollten im allgemeinen zwischen 35 und 70°C, bevorzugt zwischen 40 und 60°C, liegen.

Die Mischpolymerisate werden durch Polymerisation in der Masse, d. h. ohne Zusatz von wesentlichen Mengen Lösungs- oder Dispergierhilfsmitteln, in Gegenwart eines radikalbildenden Polymerisationsinitiators dergestellt.

Die Herstellung erfolgt in üblicher Weise in flachen Behältern, um eine bessere Temperaturkontrolle zu ermöglichen. Als Initiatoren werden in bekannter Weise Peroxide oder Azoverbindungen verwendet, die beim Erwärmen Radikale bilden. Um eine gleichmäßige Molekulargewichtsverteilung zu erhalten, ist es zweckmäßig, eine kleine Menge eines Kettenreglers, z. B. einer Mercaptoverbindung zuzusetzen. Auch kann man eine kleine Menge, z. B. weniger als 10 Gew.-% des Monomerengemisches eines Lösungsmittels, z. B. Wasser oder einen niederen Alkohol, zusetzen. Die Temperatur kann zwischen etwa 30 und 130°C liegen.

Das Herstellungsverfahren hat offenbar wesentlichen Einfluß auf die Flexibilität und Elastizität des Mischpolymerisats, d. h. die Eigenschaften, die für den Einsatz des Gemisches als Trockenresist für die Tenting-Technik wesentlich sind.

Die erfindungsgemäßen Gemische enthalten polymerisierbare Verbindungen mit mindestens zwei endständigen ethylenischen Doppelbindungen. Als polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1.000, Neopentylglykol, Trimethylolethan und -propan, Pentaerythrit und oxyethylierte Bisphenol-A-Derivate. Besonders geeignet sind Urethangruppen enthaltende Bisacrylate und Bismethacrylate, die durch Umsetzung von 1 mol eines Diols mit 2 mol eines Diisocyanats und 2 mol Hydroxyalkylacrylat oder -methacrylat erhalten werden. Derartige Urethangruppen enthaltende Monomere sind in der DE-A-2 822 190 beschrieben. Ähnliche Monomere sind in der DE-A-3 048 502 beschrieben.

Als durch Strahlung, insbesondere aktinisches Licht aktivierbare Polymerisationsinitiatoren in dem erfindungsgemäßen Gemisch können eine Vielzahl von Substanzen Verwendung finden. Beispiele sind Benzoin und seine Derivate, Trichlormethyl-s-triazine, Trihalogenmethylgruppen enthaltende Carbonylmethylenheterocyclen, z. B. 2-(p-Trichlormethyl-benzoylmethylen)-3-ethyl-benzthiazolin, Acridinderivate, z. B. 9-Phenyl-acridin, 9-p-Methoxy-phenyl-acridin, 9-Acetylamino-acridin, Benz(a)acridin; Phenazinderivate, z. B. 9,10-Dimethyl-benz(a)phenazin, 10-Methoxy-benz(a)phenazin, Chinoxalinderivate, z. B. 5,4',4''-Trimethoxy-2,3-diphenylchinoxalin, 4',4''-Dimethoxy-2,3-diphenyl-5-azachinoxalin oder Chinazolinderivate. Die Initiatoren werden allgemein in einer Menge von 0,01 bis 10, vorzugsweise von 0,05 bis 4 Gew.-% bezogen auf die nicht flüchtigen Bestandteile des Gemisches, eingesetzt.

Das erfindungsgemäße Gemisch enthält im allgemeinen 30 bis 70, bevorzugt 40 bis 60, Gew.-% Bindemittel und 30 bis 70, bevorzugt 40 bis 60 Gew.-% polymerisierbare Verbindungen, bezogen jeweils auf die Gesamtmenge an nicht flüchtigen Bestandteilen.

Das Gemisch kann als übliche weitere Bestandteile Polymerisationsinhibitoren, Wasserstoffdonatoren, sensitometrische Regler, Farbstoffe, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgenund Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind beispielsweise Aluminium, Stahl, Zink, Kupfer, Siebe oder Kunststofffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial, wobei es sich insbesondere bei Anwendung der Tenting-Technik bewährt. Dazu kann es in bekannter Weise als vorgefertigte, übertragbare Trockenresistfolie auf das zu bearbeitende Werkstück, z. B. auf Leiterplatten-Basismaterial, aufgebracht werden. Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf du Resistrollen beliebiger Breite zerschnitten werden.

Die Folien lassen sich mit in der Trockenresisttechnik üblichen Geräten verarbeiten. In einer handelsüblichen Laminiervorrichtung wird die Deckfolie abgezogen und die Photoresistschicht auf gebohrtes, verkupfertes Basismaterial auflaminiert. Die so präparierte Platte wird kann durch eine Vorlage belichtet und nach Abziehen der Trägerfolie in bekannter Weise entwickelt.

Als Entwickler sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösungsmitteln oder Netzmitteln zugesetzt werden können.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzschutzschichten oder Galvanoreserven, auf metallischen Trägern, z. B. Kupfer, verwendet.

Bei dieser Anwendung kommt die herausragende Elastizität und Zähigkeit der aus dem erfindungsgemäßen Gemisch hergestellten Photoresistschichten sowohl im unbelichteten als auch im belichteten Zustand zur Geltung. Die auf Kupfer laminierte photopolymerisierbare Schicht hat einen so festen Zusammenhalt, daß die freitragenden, die Löcher überdeckenden Schichtbereiche beim Abtrennen der Trägerfolie unbeschädigt bleiben und nicht von dieser Folie mitgerissen werden. Es ist mit Schichten aus dem erfindungsgemäßen Gemisch möglich, Löcher von 6 mm Durchmesser und darüber zu überspannen, wobei die Schicht beim Abtrennen der Folie, beim Entwickeln, Galvanisieren und bzw. oder Ätzen unbeschädigt bleibt. Trotz des hohen Molekulargewichts der Mischpolymerisate lassen sich Schichten aus den erfindungsgemäßen Gemischen mit rein wäßrigen, schwach alkalischen Entwicklerlösungen vollständig entwickeln. Die Bindemittel sind mit den üblichen Monomeren in weiteren Mengenverhältnissen besser mischbar als entsprechende Bindemittel mit niederem Molekulargewicht; ein Weichmacherzusatz ist nicht erforderlich. In gleicher Form haben die Gemische eine gute Resistenz gegen Entwickler, Ätzlösungen und Galvanisierbäder. Das erfindungsgemäße Gemisch eignet sich besonders gut zur Anwendung im Trockenresistverfahren. Es ist auch für andere Anwendungen geeignet, bei denen es auf Flexibilität und Zähigkeit einer lichtempfindlichen Schicht ankommt, so z. B. zur Herstellung von Photoresistlösungen, von Druckformen, Reliefbildern, Siebdruckschablonen und Farbprüffolien.

Die folgenden Beispiele erläutern bevorzugte Ausführungsformen des erfindungsgemäßen Gemisches und ihre Anwendung. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu cm³.

**Beispiel 1**

Eine Lösung von

| | |
|---|---|
| 6,5 Gt | des unten beschriebenen Terpolymerisats, |
| 8,8 Gt | eines durch Umsetzung von 1 mol Triethylenglykol, 2 mol 2,2,4-Trimethyl-hexamethylen-diisocyanat und 2 mol Hydroxyethylmethacrylat hergestellten polymerisierbaren Diurethans, |
| 0,25 Gt | 9-Phenylacridin und |
| 0,025 Gt | eines blauen Farbstoffs, erhalten durch Kuppeln von 2,4-Dinitro-6-chlor-benzoldiazoniumsalz mit 2-Methoxy-5-acetylamino-N,N-diethyl-anilin in |
| 15 Gt | Butanon und |
| 15 Gt | Ethanol |

wurde auf eine biaxial verstreckte und thermofixierte Polyethylenterephthalatfolie der Stärke 25 µm so aufgeschleudert, daß nach dem Trocknen bei 100° C ein Schichtgewicht von 45 g/m² erhalten wurde.

Das Terpolymerisat wurde wie folgt hergestellt: Eine Monomerenmischung aus n-Hexylmethacrylat, Methacrylsäure und Styrol im Gewichtsverhältnis 60 : 30 : 10 wurde mit 0,05 Gew.-% Azoisobuttersäurenitril, 0,02 Gew.-% tert.-Butylperisononanat und 0,5 Gew.-% tert.-Dodecylmercaptan vermischt und zur Polymerisation in flache Hohlkammern aus Stahlblech verfüllt. Das Gemisch wurde im Wasser- oder Luftbad bis zur Verfestigung auf 50° C erhitzt. Zur Erzielung eines ausreichend hohen Endumsatzes wurde noch auf 100° C erhitzt und einige Zeit bei dieser Temperatur gehalten. Nach dem Abkühlen wurden die Hohlkammern geöffnet und die entnommenen Polymerblöcke mechanisch zerkleinert. Es wurde ein Polymeres mit einer kinematischen Viskosität $v$ von 32 mm²/s (15 % in Ethanol) erhalten; das mittlere Molekulargewicht $\bar{M}_w$, durch Lichtstreuung gemessen, betrug 128.000. Die Säurezahl war 195 und der Umsatz größer als 97 %.

Die so hergestellte Trockenresistfolie wurde mit einer handelsüblichen Laminiervorrichtung bei 115° C auf eine mit 35 µm starker Kupferfolie kaschierte Phenoplast-Schichtstoffplatte laminiert und mittels einer 5-kW-Metallhalogenidlampe im Abstand von 110 cm zwischen Lampe und Vakuumkopierrahmen 8 s belichtet. Als Vorlage diente eine Strichvorlage mit Linienbreiten und Abständen bis herab zu 80 µm.

Nach der Belichtung wurde die Polyesterfolie abgezogen und die Schicht mit 1 %-iger Natriumcarbonatlösung in einem Sprühentwicklungsgerät 120 s lang entwickelt.

Die Platte wurde dann 30 s mit Leitungswasser gespült, 30 s in einer 15 %-igen Ammoniumperoxydisulfat-Lösung angeätzt, erneut mit Wasser gespült, 30 s in 10 %-ige Schwefelsäure getaucht und sodann nacheinander in den folgenden Elektrolytbädern galvanisiert:

1. 60 min in einem Kupferelektrolytbad der Firma Schlötter, Geislingen/Steige, Typ "Glanzkupfer-Bad"
Stromdichte:   2,5 A/dm²
Metallaufbau:   ca. 30 µm
Temperatur:   Raumtemperatur
2. 15 min in einem Bleizinnbad LA der Firma Schlötter, Geislingen/Steige
Stromdichte:   2 A/dm²
Metallaufbau:   15 µm
Temperatur:   Raumtemperatur

Die Platte zeigte keinerlei Unterwanderungen oder Beschädigungen.

Die Platte konnte sodann in 5 %-iger KOH-Lösung bei 50° C entschichtet und das freigelegte Kupfer in den üblichen Ätzmedien weggeätzt werden.

In einem anderen Versuch wurde die Photoresistschicht auf eine mit Kupfer kaschierte Testplatte mit Bohrungen zwischen 1 und 6 mm Durchmesser auflaminiert und der Resist durch eine den Bohrungen entsprechende Negativvorlage (Durchmesser der transparenten Stellen 1,4 bis 6,4 mm) belichtet. Anschließend wurden die nicht belichteten Schichtteile mit 1 %-iger Natriumcarbonatlösung ausgewaschen und das freigelegte Kupfer mit ammoniakalischer Kupferchloridlösung weggeätzt. Nach dem Ätzen waren alle Bohrlöcher mit gehärtetem Photoresist überspannt.

Zum Vergleich wurde das erfindungsgemäße Bindemittel durch ein analoges mit einem Molekulargewicht von ca. 33.000 [v (15 %-ig in Ethanol) = 11 mm$^2$/s] gemäß DE-A-2 363 806 ersetzt, das durch Polymerisation in 33 %-iger Lösung in Butanon hergestellt worden war. Es wurde eine klebrige Photoresistschicht erhalten, die nur schwer zu verarbeiten ist. Durch die geringere schichtverfestigende Wirkung des niedermolekularen Bindemittels trat beim Lagern von Resistrollen, insbesondere bei erhöhten Temperaturen, Schichtsubstanz an den Schnittkanten aus. Beim Laminieren auf ein mit Bohrungen versehenes Basismaterial bildete sich um jedes Bohrloch ein Ring mit geringerer Schichtdicke aus. Eine derartige Schicht war nicht für die Tenting-Technik einsetzbar.

Auch die in der DE-A-2 363 806, Beispiel 4, oder der DE-A-2 822 190, Beispiel 1, beschriebenen Trockenresistschichten, die beide das obige Bindemittel enthalten, sind nicht zum Überspannen von mehr als 1 mm weiten Bohrlöchern geeignet.

## Beispiel 2

Vergleichbare Ergebnisse wurden erzielt, wenn anstelle des in Beispiel 1 angegebenen Urethans folgende Monomermischungen eingesetzt wurden:

a) 5,8 Gt des Urethans aus Beispiel 1 und 1,5 Gt Triethylenglykoldimethacrylat,

b) 5,8 Gt des Urethans aus Beispiel 1 und 1,5 Gt Polyethylenglykol-400-dimethacrylat.

Der Vorteil dieser Photoresistschichten liegt in der kürzeren Entwicklungszeit.

|  | Schicht von Beispiel | | |
|---|---|---|---|
| Entwicklungszeit | 1 | 2a | 2b |
| (s) | 95 | 75 | 75 |

## Beispiel 3

In der in Beispiel 1 beschriebenen Beschichtungslösung wurden statt des dort beschriebenen Bindemittels gleiche Mengen der folgenden Terpolymeren eingesetzt:

a) Terpolymerisat aus n-Hexylmethacrylat, Methacrylsäure und Styrol (60 : 30 : 10) mit einem mittleren Molekulargewicht ($\bar{M}_w$) von ca. 185.000, einer kinematischen Viskosität v (15 %-ig in Ethanol) von 74 mm$^2$/s und einer Säurezahl von 195,

b) Terpolymerisat aus n-Hexylmethacrylat Methacrylsäure und Styrol (60 : 35 : 5) mit einem $\bar{M}_w$ von 74.000, einer kinematischen Viskosität v (15 %-ig in Ethanol) von 23 mm$^2$/s und einer Säurezahl von 228,

c) Terpolymerisat aus n-Hexylmethacrylat, Methacrylsäure und Styrol (60 : 35 : 5) mit einem $\bar{M}_w$ von 94.000, einer kinematischen Viskosität v (15 %-ig in Ethanol) von 32 mm$^2$/s und einer Säurezahl von 228,

d) Terpolymerisat aus n-Hexylmethacrylat, Methacrylsäure und Methylmethacrylat (60 : 35 : 5) mit einer kinematischen Viskosität v(15 %-ig in Ethanol) von 36 mm$^2$/s und einer Säurezahl von 228,

e) Copolymerisat aus n-Hexylmethacrylat und Methacrylsäure (65 : 35) mit einer kinematischen Viskosität v (15 %-ig in Ethanol) von 34 mm$^2$/s und einer Säurezahl von 228.

In allen Fällen wurde eine einwandfreie Überspannung der Bohrlöcher (Tenting) erzielt.

## Beispiel 4

Es wurde eine Beschichtungslösung hergestellt aus:

| | |
|---|---|
| 4 Gt | des in Beispiel 1 beschriebenen Terpolymerisats |
| 4 Gt | eines durch Umsetzung von 1 mol 2,2,4-Trimethyl-hexamethylen-diisocyanat mit 2 mol Hydroxyethylmethacrylat erhaltenen Diurethans, |
| 0,17 Gt | 9-Phenylacridin, |
| 0,02 Gt | eines blauen Farbstoffs, erhalten durch Kuppeln von 2,4-Dinitro-6-chlor-benzoldiazoniumsalz mit 2-Methoxy-5-acetylamino-N-cyanoethyl-N-hydroxyethyl-anilin und |
| 0,01 Gt | 5-Nitro-2-[2-methyl-4-(N-ethyl-N-cyanoethyl)-amino-benzolazo-] benzthiazol in |
| 17 Gt | Butanon und |
| 56 Gt | Ethylenglykolmonomethylether. |

Die Lösung wurde auf elektrochemisch aufgerauhtes und anodisiertes Aluminium mit einer Oxidschicht von 2 g/m², das mit einer wäßrigen Lösung von Polyvinylphosphonsäure vorbehandelt war, so aufgeschleudert, daß ein Trockengewicht von 3,5 g/m² erhalten wurde. Anschließend wurde die Platte mit einer Polyvinylalkohol-Deckschicht von 4 g/m² versehen. Die Druckplatte wurde halbiert, und beide Hälften wurden mittels einer 5-kW-Metallhalogenidlampe unter einem 13-stufigen Halbtonkeil sowie unter einem 60er- und 120er-Rasterstufenkeil 2 s belichtet. Eine Hälfte wurde zusätzlich nach dem Belichten 5 s bei 100°C im Umlufttrockenschrank erhitzt.

Anschließend wurde mit einem Entwickler folgender Zusammensetzung entwickelt:

| 3,0 Gt | Natriummetasilikat · 9 H₂O, |
|---|---|
| 0,03 Gt | nichtionogenes Netzmittel (Kokosfettalkohol-Polyoxyethylenether mit ca. 8 Oxyethyleneinheiten), |
| 0,003 Gt | Antischaummittel und |
| 96,967 Gt | vollentsalztes Wasser. |

Ohne Nacherhitzung wurden 8(9), mit Nacherhitzung 11 (12) vollvernetzte Keilstufen erhalten.

## Patentansprüche

1. Durch Strahlung polymerisierbares Gemisch, das als wesentliche Bestandteile

a) eine radikalisch polymerisierbare Verbindung mit mindestens zwei endständigen ethylenisch ungesättigten Gruppen und mit einem Siedepunkt oberhalb 100°C bei Normaldruck,
b) eine Verbindung, die unter Einwirkung von aktinischer Strahlung die Polymerisation der Verbindung a) zu initiieren vermag, und
c) ein wasserunlösliches, in wäßrig alkalischen Lösungen lösliches Mischpolymerisat aus
c1) einer α, β -ungesättigten aliphatischen Carbonsäure,
c2) einem Alkylmethacrylat mit mindestens 4 Kohlenstoffatomen in der Alkylgruppe und gegebenenfalls
c3) einer mit c1) und c2) mischpolymerisierbaren monomeren ethylenisch ungesättigten Verbindung enthält, deren zugehöriges Homopolymerisat eine Glastemperatur von mindestens 80°C hat,

dadurch gekennzeichnet, daß das Mischpolymerisat ein mittleres Molekulargewicht im Bereich von etwa 50.000 bis 200.000 hat und durch Polymerisation in der Masse hergestellt worden ist.
2. Durch Strahlung polymerisierbares Gemisch nach Anspruch 1, dadurch gekennzeichnet, daß das Mischpolymerisat Einheiten c3 von Styrol oder einem substituierten Styrol enthält.

3. Durch Strahlung polymerisierbares Gemisch nach Anspruch 1, dadurch gekennzeichnet, daß die polymerisierbare Verbindung ein Acryl- oder Methacrylsäureester eines mehrwertigen Alkohols ist.
4. Durch Strahlung polymerisierbares Gemisch nach Anspruch 1, dadurch gekennzeichnet, daß das Mischpolymerisat 20 bis 60 mol-% Einheiten von α, β-ungesättigter Carbonsäure enthält.
5. Durch Strahlung polymerisierbares Gemisch nach Anspruch 1, dadurch gekennzeichnet, daß die α, β -ungesättigte Carbonsäure Acryl- oder Methacrylsäure ist.

## Claims

1. A radiation-polymerizable mixture which contains, as essential components,

a) a compound which can undergo free radical polymerization, contains at least two terminal ethylenically unsaturated groups and has a boiling point of above 100°C under atmospheric pressure,
b) a compound which is capable of initiating the polymerization of compound a) under the action of actinic radiation, and
c) a water-insoluble copolymer which is soluble in aqueous alkaline solutions and comprises
c1) an α, β-unsaturated aliphatic carboxylic acid,
c2) an alkyl methacrylate having at least 4 carbon atoms in the alkyl group and, if appropriate,
c3) a monomeric ethylenically unsaturated compound which is copolymerizable with c1) and c2) and whose homopolymer has a glass transition temperature of at least 80°C,

wherein the cooolymer has a mean molecular weight in the range from about 50,000 to 200,000 and is prepared by mass polymerization.
2. A radiation-polymerizable mixture as claimed in claim 1, wherein the copolymer contains units c3 of styrene or a substituted styrene.
3. A radiation-polymerizable mixture as claimed in claim 1, wherein the polymerizable compound is an acrylate or methacrylate of a polyhydric alcohol.
4. A radiation-polymerizable mixture as claimed in claim 1, wherein the copolymer contains 20 to 60 mole % of units of an α, β-unsaturated carboxylic acid.
5. A radiation-polymerizable mixture as claimed in claim 1, wherein the α, β-unsaturated carboxylic acid is acrylic acid or methacrylic acid.

## Revendications

1. Mélange polymérisable par irradiation, contenant en tant que composants essentiels

a) un composé polymérisable par polymérisation radicalaire, comportant au moins deux groupes terminaux à insaturation éthylénique et ayant un point d'ébullition supérieur à 100°C sous la pression atmosphérique,

b) un composé qui, sous l'effet d'un rayonnement actinique, permet le déclenchement de la polymérisation du composé a) et

c) un copolymère insoluble dans l'eau, soluble dans des solutions aqueuses alcalines, à base de c1) un acide carboxylique aliphatique α, β-insaturé,

c2) un méthacrylate d'alkyle ayant au moins 4 atomes de carbone dans le groupe alkyle, et éventuellement c3) un composé monomère à insaturation éthylénique copolymérisable avec c1 et c2, dont l'homopolymère correspondant a une température de transition vitreuse d'au moins 80°C.

caractérisé en ce que le copolymère a un poids moléculaire moyen dans la plage d'environ 50 000 à 200 000, et a été obtenu par polymérisation dans la masse.

2. Mélange polymérisable par irradiation selon la revendication 1, caractérisé en ce que le copolymère contient des motifs c3 de styrène ou d'un styrène substitué.

3. Mélange polymérisable par irradiation selon la revendication 1, caractérisé en ce que le composé polymérisable est un ester acrylique ou méthacrylique d'un polyalcool.

4. Mélange polymérisable par irradiation selon la revendication 1, caractérisé en ce que le copolymère contient de 20 à 60 % en mole de motifs acide carboxylique α, β-insaturé.

5. Mélange polymérisable par irradiation selon la revendication 1, caractérisé en ce que l'acide carboxylique α, β-insaturé est l'acide acrylique ou méthacrylique.